# EUROPEAN PATENT APPLICATION

(11) **EP 3 457 428 A1**
(43) Date of publication of application: **20.03.2019**
(21) Application number: 18195501.4
(22) Date of filing: 19.09.2018
(51) Int. Cl.: H01J 37/34, C23C 14/34

(54) **SYNC CONTROLLER FOR HIGH IMPULSE MAGNETRON SPUTTERING**

(30) Priority: 19.09.2017 US 201762560515 P; 23.07.2018 US 201816043117
(71) Applicant: Applied Materials, Inc., Santa Clara, CA 95054 (US)
(72) Inventor: Babayan, Viachslav, Sunnyvale, CA California 94086 (US); Hua, Zhong Qiang, Saratoga, CA California 95070 (US); Wu, Menglu, Santa Clara, CA California 95054 (US); Allen, Adolph Miller, Oakland, CA California 94605 (US); Citla, Bhargav, Fremont, CA California 94536 (US)
(74) Representative: Zimmermann & Partner Patentanwälte mbB

(57) **Abstract**

Embodiments presented herein relate to a method of and apparatus for processing a substrate in a semiconductor processing system. The method begins by initializing a pulse synchronization controller coupled between a pulse RF bias generator and a HIPIMs generator. A first timing signal is sent by the pulse synchronization controller to the pulse RF bias generator and the HIPIMs generator. A sputtering target and an RF electrode disposed in a substrate support is energized based on the first timing signal. The target and the electrode is de-energized based on an end of the timing signal. A second timing signal is sent by the pulse synchronization controller to the pulse RF bias generator and the electrode is energized and de-energized without energizing the target in response to the second timing signal.

## Description

### BACKGROUND

### Field

Embodiments described herein generally relate to a substrate processing system, and more specifically, to a pulse shape system for use in a process chamber.

### Description of the Related Art

As the semiconductor industry introduces new generations of integrated circuits (ICs) having higher performance and greater functionality, the density of the elements that form those ICs is increased, while the dimensions, size, and spacing between the individual components or elements are reduced. While in the past such reductions were limited only by the ability to define the structures using photolithography, device geometries having dimensions measured in micrometers or nanometers have created new limiting factors, such as the conductivity of the conductive interconnects, the dielectric constant of the insulating material(s) used between the interconnects, etching the small structures or other challenges in 3D NAND or DRAM form processes. These limitations may be benefited by more durable, higher thermal conductivity and higher hardness hardmasks.

HiPIMS is a method for physical vapor deposition of thin films which is based on magnetron sputter deposition. HiPIMS utilizes extremely high power densities of the order of kW/cm² in short pulses (impulses) of tens of microseconds at low duty cycle of < 40%, such as a duty of about 10%. During high power impulse magnetron sputtering (HiPIMS) deposition of carbon films, 25 µs pulses of up to -2kV may be applied to the target at a frequency between 2-8 kHz. For a carbon target, currents in a substrate process chamber may spike up to a 150A peak. Conventional HiPIMS deposition of carbon films result in a rough columnar film. In order to make the film more amorphous and dense, RF can be used. RF bias increases the carbon ion energy and makes deposited film more dense. However, RF bias in conventional continuous wave mode causes high film stress. One way to mitigate film stress is to pulse RF bias such that RF only turns on when source HV DC pulse is on. However, the carbon film morphology doesn't improve enough because there is no bombardment of carrier ions (krypton) when the HiPIMS HV pulse is off.

Therefore, there is a need for an improved substrate processing system for depositing films with improved carbon film morphology without increasing the carbon film stress.

### SUMMARY

Embodiments presented herein relate to a method of and apparatus for processing a substrate in a semiconductor processing system. The method begins by initializing a pulse synchronization controller coupled between a pulse RF bias generator and a HIPIMs generator. A first timing signal is sent by the pulse synchronization controller to the pulse RF bias generator and the HIPIMs generator. A sputtering target and an RF electrode disposed in a substrate support is energized based on the first timing signal. The target and the electrode is de-energized based on an end of the timing signal. A second timing signal is sent by the pulse synchronization controller to the pulse RF bias generator and the electrode is energized and de-energized without energizing the target in response to the second timing signal.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments.
Figure 1 illustrates a physical vapor deposition (PVD) process chamber suitable for sputter depositing materials using a high power impulse magnetron sputtering (HiPIMS) process, according to one embodiment.
Figure 2 illustrates a partial schematic block diagram showing a power delivery system for a target pulse and an RF bias pulse in the high power impulse magnetron sputtering.
Figure 3 illustrates a signal voltage for the target pulse and RF bias pulse in a first embodiment using a single synchronization signal.
Figure 4 illustrates a signal voltage for the target pulse and RF bias pulse in a second embodiment using a dual synchronization signal.
Figure 5 is a method of syncing a target pulse with an RF bias pulse during high power impulse magnetron sputtering (HIPIMs).

For clarity, identical reference numerals have been used, where applicable, to designate identical elements that are common between figures. Additionally, elements of one embodiment may be advantageously adapted for utilization in other embodiments described herein.

### DETAILED DESCRIPTION

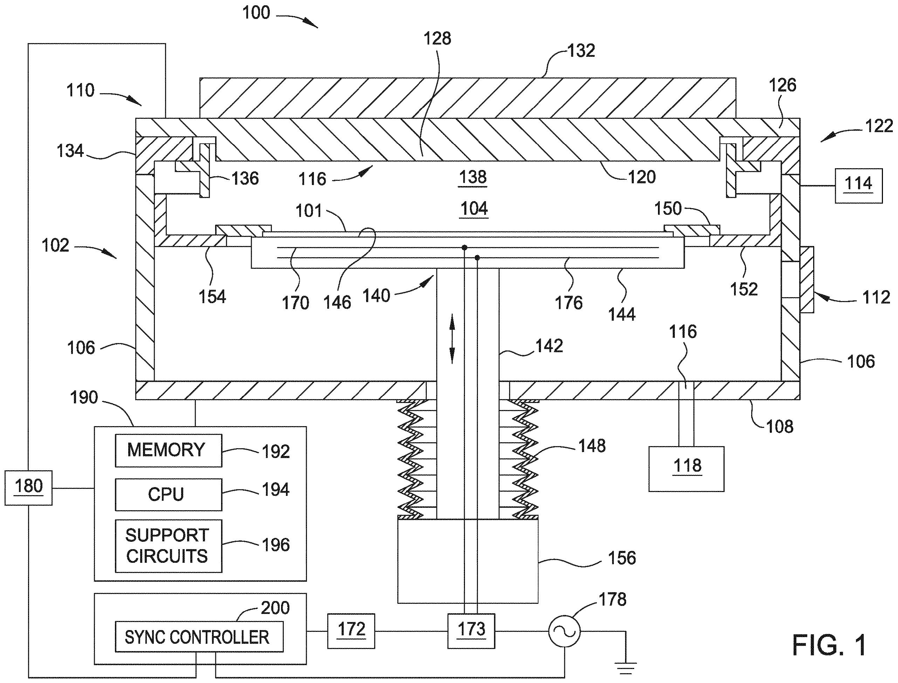

Figure 1 illustrates a physical vapor deposition (PVD) process chamber 100 (e.g., a sputter process chamber) suitable for sputter depositing materials using a high power impulse magnetron sputtering (HiPIMS) process. The process chamber may also be referred to as a processing chamber herein. The process chamber 100 includes a chamber body 102 defining a processing volume 104. The chamber body 102 includes sidewalls 106 and a bottom 108. A substrate support assembly 140 is disposed in the processing volume 104. A chamber lid assembly 110 is mounted on the top of the chamber body 102. The chamber body 102 may be fabricated from aluminum or other suitable materials. A substrate access port 112 is formed through the sidewall 106 of the chamber body 102, facilitating the transfer of a substrate 101 into and out of the process chamber 100. The access port 112 may be in communication with a transfer chamber, and/or other chambers, of a substrate processing system.

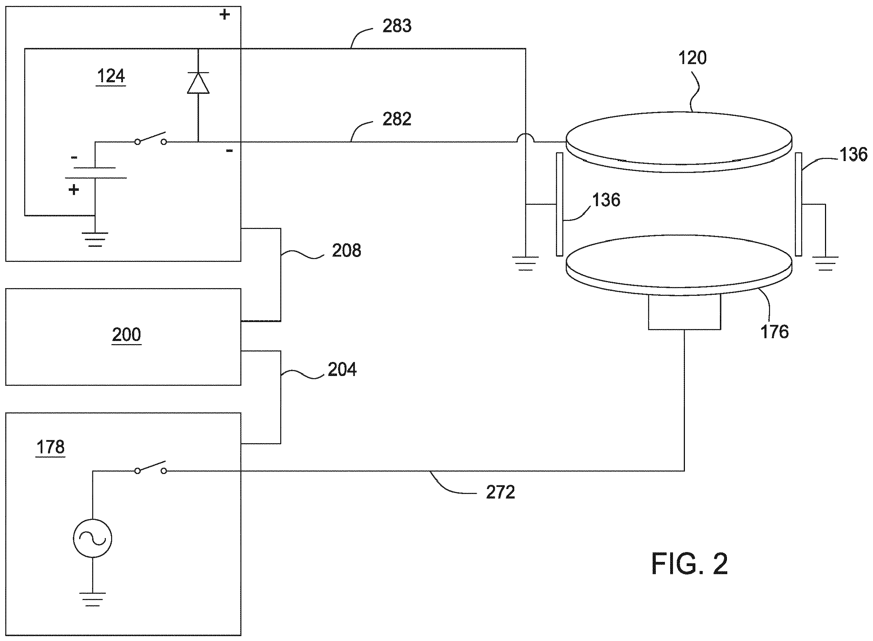

The chamber lid assembly 110 generally includes a target 120 and a ground shield assembly 122 coupled thereto. The target 120 provides a material source that can be sputtered and deposited onto the surface of the substrate 101 during a PVD process. The target 120 serves as the cathode of the plasma circuit during DC sputtering. The target 120 may be fabricated from a material utilized for the deposition layer, or elements of the deposition layer to be formed in the chamber. A high voltage power supply, such as a power source 124 (discussed in more detail in Figure 2), is connected to the target 120 to facilitate sputtering materials from the target. In one embodiment, the target 120 may be fabricated from a carbon containing material, such as graphite, amorphous carbon, combinations thereof, or the like.

The target 120 generally includes a peripheral portion 126 and a central portion 128. The peripheral portion 126 is disposed over the sidewalls 106 of the process chamber 100. The central portion 128 of the target 120 may have a curved surface slightly extending towards the surface of the substrate 101 disposed on the substrate support assembly 140. In one embodiment, the spacing between the target 120 and the substrate support assembly 140 is maintained between about 50 mm and about 250 mm.

The chamber lid assembly 110 may further comprise a magnetron cathode 132. In one embodiment, the magnetron cathode 132 is mounted above the target 120, which enhances efficient sputtering materials from the target 120 during processing. The magnetron cathode 132 allows efficient process control and tailored film properties, while ensuring consistent target erosion and uniform deposition across the substrate 101.

The ground shield assembly 122 of the lid assembly 110 includes a ground frame 134 and a ground shield 136. The ground shield 136 is coupled to the peripheral portion 126 by the ground frame 134 defining an upper processing region 138 below the central portion 128 of the target 120 in the processing volume 104. The ground frame 134 is configured to electrically insulate the ground shield 136 from the target 120 while providing a ground path to the chamber body 102 of the process chamber 100 through the sidewalls 106. The ground shield 136 is configured to constrain the plasma generated during processing within the upper processing region 138 so that ions from the plasma dislodges target source material from the central portion 128 of the target 120 so that the dislodged target source material to be mainly deposited on the substrate surface rather than the sidewalls 106.

The substrate support assembly 140 includes a shaft 142 and a substrate support 144 coupled to the shaft 142. The substrate support 144 includes a substrate receiving surface 146 configured to support the substrate 101 during processing. The shaft 142 extends through the bottom 108 of the chamber body 102 and is coupled to a lift mechanism 156. The lift mechanism 156 is configured to move the substrate support 144 between a lower transfer position and an upper processing position. A bellows 148 circumscribes the shaft 142 and is configured to provide flexible seal between the chamber body 102 and the shaft 142.

The substrate support 144 may be configured as an electrostatic chuck that has an electrode 170 embedded within a dielectric body. The substrate support 144, when configured as the electro-static chuck (ESC), uses the attraction of opposite charges to hold the substrate 101. A DC power supply 172 is coupled to the electrode 170 through a match circuit 173. The DC power supply 172 may provide a DC chucking voltage of about 200 to about 2000 volts to the electrode 170. The DC power supply 172 may also include a system controller for controlling (not shown) the operation of the electrode 170 by directing a DC current to the electrode 170 for chucking and dechucking the substrate 101.

A bias may be provided to a bias electrode 176 in the substrate support 144 from a bias source 178 through an RF match circuit 173. The RF match circuit 173 optimizes power delivery to the bias electrode 176 from the bias source 178 and adjusts or tunes the power provided to the bias electrode 176 from the bias source 178. The bias electrode 176, when in an on state, causes the substrate 101 to be bombarded with ions formed in the plasma during one or more phases of the deposition process.

The process chamber 100 may further include a shadow frame 150 and a chamber shield 152. The shadow frame 150 is disposed on the periphery of the substrate support assembly 140. The shadow frame 150 is configured to confine deposition of source material sputtered from the target 120 to a desired portion of the substrate surface. The chamber shield 152 may be disposed on the inner wall of the chamber body 102. The chamber shield 152 includes a lip 154 extending inward, towards to the processing volume 104. The lip 154 is configured to support the shadow frame 150 disposed around the substrate support assembly 140. As the substrate support 144 is raised to the upper position for processing, an outer edge of the substrate 101, disposed on the substrate receiving surface 146, engages the shadow frame 150 and lifts the shadow frame 150 up and away from the chamber shield 152. When the substrate support 144 is lowered to the transfer position, adjacent to the access port 112, the shadow frame 150 is set back on the chamber shield 152. Lift pins (not shown) are selectively moved through the substrate support 144 to lift the substrate 101 above the substrate support 144 to facilitate access to the substrate 101 by a transfer mechanism, such as a robot (not shown).

A gas source 114 is coupled to the chamber body 102 to supply process gases into the processing volume 104. In one embodiment, process gases may include one or more of inert gases, non-reactive gases, and reactive gases. Examples of process gases that may be provided by the gas source 114 include, but are not limited to, argon gas (Ar), helium (He), neon gas (Ne), krypton (Kr), etc.

The process chamber 100 further includes a pumping port 116 and a pumping device 118. The pumping port 116 may be formed through the bottom 108 of the chamber body 102. The pumping device 118 is coupled to the processing volume 104 to evacuate and control the pressure therein. In one example, the pumping device 118 may be configured to maintain the process chamber 100 at a pressure between about 1 mTorr and about 500 mTorr.

A system controller 190 is coupled to the process chamber 100. The system controller 190 includes a central processing unit (CPU) 194, a memory 192, and support circuits 196. The system controller 190 is configured to control the process sequence, regulating the gas flows from the gas source 114, and controlling ion bombardment of the target 120. The CPU 194 may be of any form of a general purpose computer processor that can be used in an industrial setting. The software routines can be stored in the memory 192, such as random access memory (RAM), read only memory (ROM), floppy or hard disk drive, or other form of digital storage. The support circuits 196 are conventionally coupled to the CPU 194. The software routines, when executed by the CPU 194, transform the CPU into a specific purpose computer (system controller 190) that controls the process chamber 100, such that the processes are performed in accordance with the present disclosure. The software routines may also be stored and/or executed by a second controller (not shown) that is located remotely from the process chamber 100. During processing, material is sputtered from the target 120 and deposited on the surface of the substrate 101. In some configurations, the target 120 is biased relative to the ground or the substrate support 144, by the power source 124 to generate and maintain a plasma formed from the process gases supplied by the gas source 114. The ions generated in the plasma are accelerated toward and strike the target 120, causing target material to be dislodged from the target 120. The dislodged target material forms a layer on the substrate 101 with a desired crystal structure and/or composition. RF, DC, or fast switching pulsed DC power supplies, or combinations thereof, provide tunable target bias for precise control of sputtering composition and deposition rates for the nanocrystalline diamond material.

HiPIMS PVD carbon film may not meet the specified roughness/morphology when the RF bias is turned off. RF bias in a continuous wave (CW mode) makes the film dense and smooth but causes high stress, for example stress greater than -3GPa, which results in 300um or greater of wafer bow for a 1kA thick film. Meanwhile, pulsing the RF bias in a pulse mode increases the film density by enhancing carbon ion energy. However, the film morphology doesn't improve enough because there is no bombardment of carrier ions (krypton) when the HiPIMS high voltage (HV) pulse is turned off. A synchronization controller 200 is provided that can output two synchronization pulses for each HiPIMS HV pulse to increase the bombardment of carrier ions when the HiPIMS high voltage (HV) pulse is turned off for improving film morphology (density) while minimizing film stress. For example, one sync pulse may be used to turn on RF bias while HiPIMS pulse is on to densify the film with carbon. A second pulse may be turned on while HiPIMS is off to treat the film with the carrier gas to improve film morphology. Both pulse durations can be tuned separately to achieve optimal film properties while minimizing film stress. Either of the pulses can also be completely turned off for maximum tuning ability. The synchronization controller may tune the process to achieve acceptable a roughness between about 0.4 nm and about 1 nm and stress between about -0.2GPa to about -4GPA which results in an acceptable bow between about 10um to about 300um for 1kA thick films. Similar results may be obtained in up to 2um thick films. The synchronization controller 200 may be part of the system controller 190 or may be provided as a separate controller, for example, an external controller in communication with the system controller 190.

Figure 2 illustrates a partial schematic block diagram showing the power delivery system for a target pulse and an RF bias pulse in the high power impulse magnetron sputtering of Figure 1. The synchronization controller 200 is suitable for sputter depositing materials using a high power impulse magnetron sputtering (HiPIMS) process and may be provided as shown above in the PVD process chamber 100. The synchronization controller 200 is coupled to the power source 124 and the bias source 178. According to embodiments of the present disclosure, a bias source may also be referred to as RF bias source or RF bias generator. Additionally or alternatively, a power source may also be referred to as target power source. For example, the synchronization controller 200 may have a first connection 208 for communicating with the power source 124. Additionally, the synchronization controller 200 may have a second connection 204 for communicating with the bias source 178. The power source 124 has a pulse signal path 282 and a pulse return path 283 (The pulse shape controller is not shown). The bias source 178 has a bias channel 272 in communication with the bias electrode 176, i.e., RF mesh, embedded in the substrate support 144 (The pulse shape controller is not shown). The bias channel 272 communicates through the RF match 173 shown in Figure 1 and is not shown here in Figure 2 for simplicity.

During HiPIMS PVD Carbon film deposition, the HiPIMS source generator (power source) 124 controls the high power sputtering operation. The bias source 178 controls the energy of the sputter material directed to the substrate 101. The RF bias controller energizing the bias electrode 176 to attract sputter material toward the substrate 101 wherein the greater the bias, the greater the energy of the sputter material directed toward the substrate 101. The synchronization controller 200 provides instructions for the operation of both the power source 124 and the Bias source 178. The synchronization controller 200 has a clock and is configurable to delay and control the duty cycle for the power source 124 and the Bias source 178. The synchronization controller 200 provides one or more signal voltages for independently controlling both the power source 124 and the Bias source 178. The operations of the power source 124 and the Bias source 178 may therefore be harmonized. For example, the synchronization controller 200 may provide one synchronization pulse to the Bias source 178 configured to turn on the RF bias during the HIPIMS HV pulse which enhances carbon ion bombardment of the substrate surface and/or another synchronization pulse configured to turn on the RF bias when the HiPIMS is off for enabling surface treatment of the substrate by the carrier gas. The power source 124 and the Bias source 178 delays and 'on times' can be independently set by the synchronization controller 200 to achieve tuning flexibility. Continuous wave biased deposition improves film morphology/surface roughness and film density (RI) while increasing film stress. The synchronization controller 200 opens up new processing windows for controlling the morphology/ surface roughness by synchronizing the bias to improved film surface roughness /morphology and refractive index (RI) with reduced film stress in comparison to continuous wave (CW) mode. The RI measurements of nanoscale porous film are associated with measurements of film density. The surface roughness is reported in nanometers (nm) with the nm root-mean-square (RMS) units indicating the average roughness across the whole substrate surface. The synchronization controller 200 allows a higher bias power to improve the surface roughness and morphology without increasing the film stress beyond acceptable levels, i.e., above 0.5 GPa.

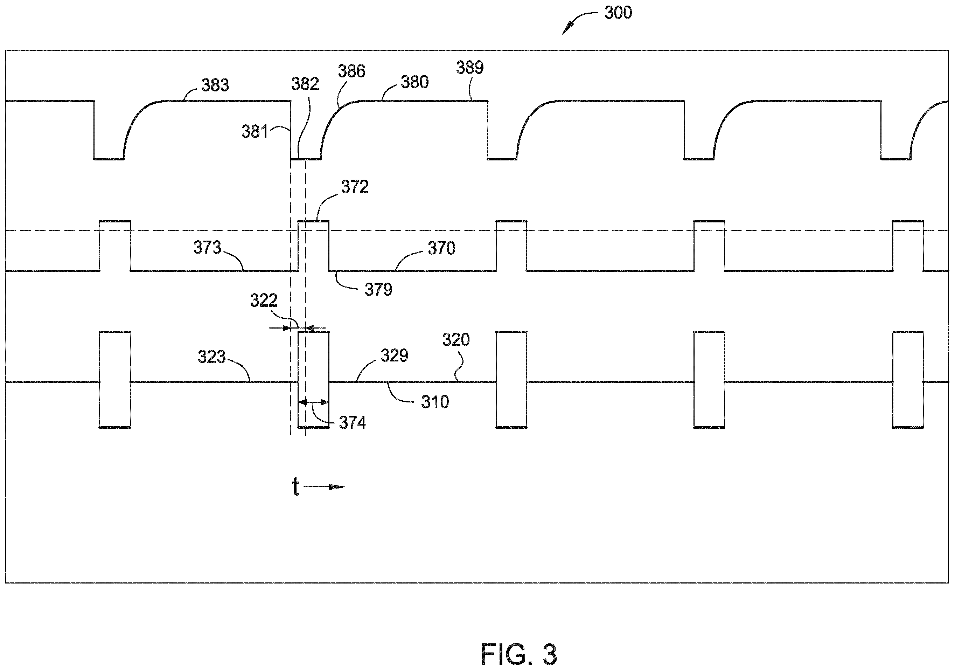

Figure 3 illustrates the target pulse 380 and RF bias pulse 320 in a first embodiment using a single synchronization signal 370. Although the x-axis is an expression of time common to each of the plots, the y-axis for each of the target pulse 380, RF bias pulse 320 and synchronization signal 370 have their own corresponding scale with positive larger values extending upward. The value along the y-axis for the target pulse 380 is larger than that of the RF bias pulse 320 in the graph above without scale. For example, the target may be about 2kV, the bias is about a few hundred volts, and the sync signal is a low voltage less than 24V such as about 5V.

The synchronization controller 200 provides the single synchronization signal 370. The single synchronization signal 370 may be a signal voltage 379. The signal voltage 379 may move between an on state 372 and an off state 373. The signal voltage 379 may have a voltage at about zero in the off state 373. Alternately, the voltage at the off state 373 may be any steady state reference voltage, i.e., about 5V. The on state 372 may have a voltage measurably different than the off-state. For example, the voltage difference between the off state 373 and the on state 372 may be between about 1 volt and about 10 volts. It should be appreciated that any measureable signal property may be used to communicate either the off state 373 or the on state 372.

The synchronization signal 370 may be synchronized to a clock of the synchronization controller 200. The off state 373 or the on state 372 may correspond to units of time such as second, tens of seconds, fractions of a second, or other appropriate unit of time. It should be appreciated that the time intervals for either the off state 373 or the on state 372 may be any appropriate interval dictated be process and performance. For example, the on state 372 may last 50 microseconds followed by a 200 microsecond off state. In this way, the timing and/or synchronization of the target pulse 380 and RF bias pulse 320 is highly configurable.

The target pulse 380 has a low voltage state 389 and a high voltage state 382. The target pulse 380 is off in the low voltage state 389. The target pulse 380 may be expressed as a negative bias voltage and operate in a range between about (-2kV) at the high voltage state 382, and a reference voltage, such as a ground voltage, or other low voltage, such as about -100 V at the low voltage state 389. At a time zero 381, the target pulse 380 may be set to the high voltage state 382. When the target pulse 380 is switched off, high voltage state 382 decays 386 until reaching the low voltage state 389. During the high voltage state 382, gas in the process cavity ionizes and positive ions from the gas accelerate towards the target and thus knock off (or sputter) target material which ends up depositing on the substrate that is located directly below the target. Electrons from the ionized gas travel away from the target towards the ground shield. In one embodiment, the target pulse 380 at a first low voltage state 383, such as about 0V, is switched on at time zero 0 to the high voltage state 382 of approximately -1.9KV. After time t, the target pulse 380 is turned off and decays 386 while providing less and less material from the target until the target pulse 380 is about 0V.

The RF bias pulse 320 has a bias voltage 310. The bias voltage 310 generally provides both a bias state 324 and a non-bias state 323. The bias state 324 attracts the ions formed in the chamber environment from the process gas and sputtered material toward the surface of the substrate. The RF bias pulse 320 may operate between about 0 (zero) watts at non-bias state 323 and about 600 volts in a bias state 324. The compressive stress of the film deposited on the substrate 101 is proportionally related to the bias voltage 310. Additionally, the density as measured by the refractive index of the film deposited on the substrate 101 is proportionally related to the bias voltage 310. As the bias voltage 310 increases, the film density increases along with the film stress.

The RF bias pulse 320 may operate in a continuous wave or synched with the synchronization controller 200 to the target pulse 380. Film utilizing the continuous wave generates better film density, morphology and roughness than a baseline of no bias. However, the resulting film stress is undesirably high. A good 1K angstrom film roughness may be about 1 nm RMS or less while having a film stress below 0.5 GPa or less. The following provide example results for film morphology on a substrate processed in the HiPIMS system described above wherein the system parameters provide a carbon target, krypton processing gas, and synchronized RF bias generator with HiPIMS source generator.

A series of examples are provided below in table 1. While keeping source generator parameters fixed, the trend shows as RF bias power is increased, surface roughness gets better, refractive Index and hence density gets better but compressive stress gets worse

**Table 1**

| | Example 1 | Example 2 | Example 3 |
|---|---|---|---|
| Bias Gen Power (W) | 0 | 300 | 600 |
| Surface Roughness (nm RMS) | 1.52 | 1.16 | 0.83 |
| Compressive Stress (MPa) | 315 | 1660 | 3141 |
| Refractive Index | 2.49 | 2.51 | 2.55 |

The synchronization controller 200 can output two synchronization pulses for each HiPIMS HV pulse. A first synchronization pulse is used to turn on RF bias during the HIPIMS HV pulse is in the "on" state to enhance carbon ions in the chamber. A second synchronization pulse is used to turn on RF bias when the HiPIMS is in an "off" state which enables surface treatment by the carrier gas and those carbon ions in the chamber. Both the HiPIMS HV and the bias pulses can be independently set with a delay in the on and off times for tuning flexibility. Additionally, the bias pulses can be run at lower frequencies (number of on and off cycles per second) than the source allowing for some carbon build up on the substrate between RF bias treatments to improve density and morphology without increase in stress.

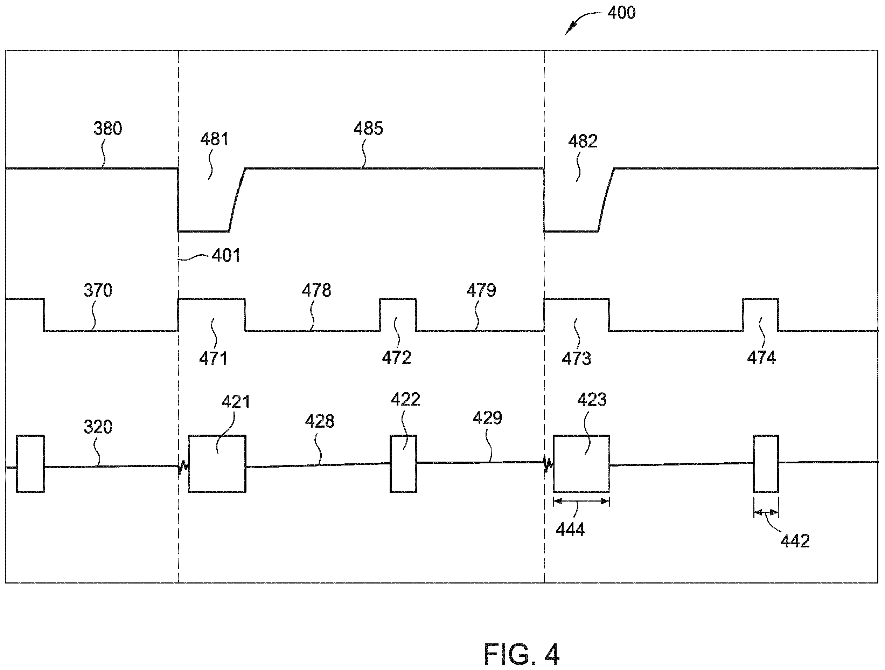

Figure 4 illustrates a signal voltage for the target pulse and RF bias pulse in a second embodiment using a dual synchronization signal. Similar to Figure 3, Figure 4 illustrates the x-axis is an expression of time common to each of the plots therein. The target pulse 380, the RF bias pulse 320 and the synchronization signal 370 are provided along the y-axis, each having their own corresponding magnitude scale.

At time zero 401 a first synchronization signal 471 is provided. The target pulse 380 may enter an "on" state 481 at the first synchronization signal 471. Additionally, the RF bias pulse 320 may enter an "on" state 421 upon the occurrence of the first synchronization signal 471. Optionally, a delay may be provided prior to the start of the RF bias pulse 320 or the target pulse 380. In one embodiment, the delay may be between about 0 µs and about 200 µs. At the end of the first synchronization signal 471, the target pulse 380 may enter an "off" state 485. Additionally, at the end of the first synchronization signal 471, the RF bias pulse 320 may enter an "off" state 428. Optionally, a delay may be provided prior to or after the synchronization signal 370 signals the "off" state 428, 485 of the RF bias pulse 320 or the target pulse 380. In other scenarios, one of the RF bias pulse 320 or the target pulse 380 may have a delay entering the on or the off state while the other either operates with a delay in the opposite on or off state or even operates without a delay. For example, upon the beginning 401 or the first synchronization signal 471, the target pulse 380 may immediate initiate the "on" state 481 while the RF bias pulse 320 experiences a delay or 3 µs prior to entering the "on" state 421. The first synchronization signal 471 enters an "off" state which immediately signals the RF bias pulse 320 and the target pulse 380 to enter the "off" state 428, 485.

The synchronization signal 370 may provide a second signal 472. The second signal 472 may have no effect on the target pulse 380 and the target pulse 380 remains in the "off" state 485. However, the second signal 472 may signal to the RF bias pulse 320 to enter a second "on" state 422. The end or duration of the second signal 472 may be substantially similar to the end or duration for the "on" state 422 of the RF bias pulse 320.

The synchronization signal 370 may provide a third synchronization signal 473. By operation of the third sync signal 473, the target pulse 380 may enter a second "on" state 482. Additionally, the RF bias pulse 320 may enter a third "on" state 423 upon the occurrence of the third sync signal 473. As discussed above, either the RF bias pulse 320 or the target pulse 380 may optionally have a delay in entering or leaving the "on" state upon a start 409 of the third sync signal 473. Additionally, either the RF bias pulse 320 or the target pulse 380 may optionally have an advance in ending the "on" state upon the third sync signal 473 ending.

The synchronization signal 370 may provide a fourth signal 474. The fourth signal 474 may have no effect on the target pulse 380 and the target pulse 380 remains in the "off" state 485. However, the fourth signal 474 may signal to the RF bias pulse 320 to enter a fourth "on" state. The length or duration of the RF bias pulse 320 may be different during the pulses which coincide with the "on" state for the RF bias pulse 320 and the target pulse 380 versus the pulses associated with the "on" state for only the RF bias pulse 320. For example, a first duration 444 associated with the third sync signal 473 may be larger than a second duration 442 associated with the fourth pulse 424.

In this manner, one can deposit a film with refractive index of 2.5, a surface roughness of less than 1nm and with stress of less than 1900MPA using the dual pulse scheme described in figure 4 while the same quality film would yield a stress of 3000 MPA using the single pulse scheme as described in figure 3. Total RF ON time and power would be the same for both films. The difference is single pulse will deliver all RF power while the source is "on", while the dual scheme would only deliver 60% of the RF power during source "on" time and the remaining power delivered during the source off time. Thereby limiting the stress induced by energetic carbon ions. One can tune the RF "on" time during both the source "on" time and "off" time to further minimize film stress. In some cases it may be beneficial to completely eliminate RF pulse when the source is "on" and only turn on the RF bias when the source if off. In one embodiment the synchronization signal 370 essentially turns on/off RF bias pulse 320, there may be a 2.5us delay from rising edge of the synchronization signal 370 to rising edge of the RF bias pulse 320. This time may coincide with the time that the RF generator needs to process the command and turn on output.

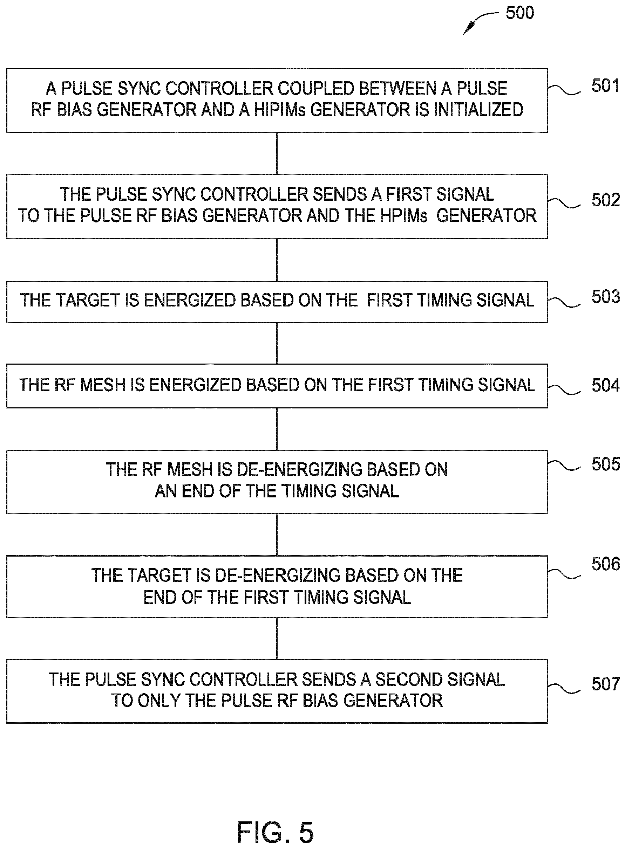

Figure 5 is a method 500 of synchronizing a target pulse with an RF bias pulse during high power impulse magnetron sputtering (HIPIMs). The method begins at block 501 wherein a pulse synchronization controller coupled between a pulse RF bias generator and a HIPIMs generator is initialized. The pulse RF bias generator is coupled to a RF mesh in a substrate support and the HIPIMs generator is coupled to a target. The pulse synchronization controller is operable to provide a signal indicating an on state and an off state wherein the pulse synchronization is initialized to be in the off state.

At block 502, the pulse synchronization controller sends a first signal to the pulse RF bias generator and the HIPIMs generator. The first timing signal operates to control the operation for both the pulse RF bias generator and the HIPIMs generator. The timing signal may provide instructions for the HIPIMs generator to begin to energize the target and the pulse RF bias generator to begin to energize the RF mesh. The instructions are treated separately by both the pulse RF bias generator and a HIPIMs generator.

At block 503, the target is energized based on the first timing signal. The HIPIMs generator energizes the target. A delay may be provided from receiving the timing signal by the HIPIMs generator energizing the target. Operational parameters for the HIPIMs generator may set the delay and/or duration of for the energization of the target. For example, the target may optionally energize the target between about zero µs and about 2 µs after the HIPIMs generator receives the first timing signal.

At block 504, the RF mesh is energized based on the first timing signal. RF bias generator energizes the RF mesh, i.e., applies an RF bias. A delay may be provided from receiving the timing signal by the RF bias generator energizing the RF mesh. Operational parameters for the RF bias generator may set the delay and/or duration of for the energization of the RF mesh. For example, the RF generator may optionally energize the RF mesh between about zero µs and 2 µs after the RF bias generator receives the first timing signal.

At block 505, the RF mesh is de-energizing based on an end of the timing signal. The end of the first timing signal is perceived by the RF bias generator. The RF bias generator may stop energizing the RF mesh upon the termination of the first timing signal. Optionally, the RF bias generator may begin a count or delay prior to stopping based on set parameters for the operation of the RF bias generator. Alternately, the RF bias generator may de-energize the RF mesh prior to the end of the first timing signal due to a shortened duration for RF mesh energization set in the operational parameters.

At block 506, the target is de-energizing based on the end of the first timing signal. The end of the first timing signal is perceived by the HIPIMs generator. The HIPIMs generator may stop energizing the target upon the termination of the first timing signal. Optionally, the HIPIMs generator may begin a count or delay prior to stopping based on set parameters for the operation of the HIPIMs generator. Alternately, the HIPIMs generator may de-energize the target prior to the end of the first timing signal due to a shortened duration for target energization set in the operational parameters.

At block 507, the pulse synchronization controller sends a second signal to only the pulse RF bias generator. Alternately, the second signal may also be sent to the HIPIMs generator. The HIPIMs generator may be configured to ignore certain sync timing signals, such as in a sequence. For example, the HIPIMs generator may ignore every other sync timing signal. The RF mesh is energized based on the second timing signal. RF bias generator energizes the RF mesh, i.e., RF bias. A delay may be provided from receiving the timing signal by the RF bias generator energizing the RF mesh. Operational parameters for the RF bias generator may set the delay and/or duration of for the energization of the RF mesh. For example, the target may optionally energize the RF mesh between about zero µs and 2 µs after the RF bias generator receives the first timing signal. The RF mesh is de-energizing based on an end of the second timing signal. The end of the second timing signal is perceived by the RF bias generator which stops energizing the RF mesh upon the termination of the first timing signal.

The method may continue by repeating blocks 501 through 507 until the desired film thickness and density is achieved. Advantageously, the synchronization controller opens up new processing windows for controlling the morphology/roughness by sync'ing the bias to improved film roughness/morphology and refractive index (RI) with reduced film stress in comparison to CW mode. The synchronization controller allows a higher bias power to improve the film roughness below about 1.00 nm without increasing the film stress beyond acceptable levels, i.e., for example above 0.5 GPa.

While the foregoing is directed to specific embodiments, other and further embodiments may be devised without departing from the basic scope thereof, and the scope thereof is determined by the claims that follow.

## Claims

1. A pulse sync system comprising:
a target power source in communication with a sputtering target disposed in a processing chamber, wherein the power source is operable to change a target bias between a first target voltage and a second target voltage;
an RF bias source in communication with an RF electrode disposed in a substrate support, wherein the RF bias source is configured to energize the RF electrode between a first electrode voltage and a second electrode voltage; and
a sync controller coupled to the RF bias source and target power source, wherein the sync controller provides a plurality of synchronization signals for the RF bias source and the target power source to enter a respective first or second voltage.

2. The pulse sync system of claim 1, wherein the sync controller further comprises:
a first on signal of a first duration configured to activate both the RF bias source and the target power source;
a first off signal of a second duration configured to deactivate the RF bias source and the target power source; and
a second on signal of a third duration configured to only activate the RF bias source.

3. The pulse sync system of claim 2, wherein the RF bias source has a delay in energizing the RF electrode upon activation of the first on signal.

4. The pulse sync system of claim 3, wherein the delay in energizing the RF electrode is about 3 µs.

5. The pulse sync system of claim 1, wherein the sync controller further comprises:
a first on signal of a first duration configured to activate both the RF bias source and the target power source;
a first off signal of a second duration configured to deactivate the RF bias source and the target power source; and
a second on signal of a third duration configured to activate both the RF bias source and the target power source.

6. The pulse sync system of claim 5, wherein the RF bias source has a delay in energizing the RF electrode upon activation of the first on signal.

7. The pulse sync system of claim 6, wherein the delay in energizing the RF electrode is about 3 µs.

8. A substrate processing system comprising:
a process chamber comprising:
a chamber body having sidewalls and a bottom;
a lid assembly positioned on the chamber body forming an interior volume, the lid assembly having a sputtering target; and
a substrate support having an electrode, the substrate support disposed in the interior volume below the lid assembly, the substrate support configured to support a substrate during processing; and
a pulse sync system according to any of claims 1 to 7.

9. A method of syncing a target pulse with an RF bias pulse during high power impulse magnetron sputtering (HIPIMs), the method comprising:
initializing a pulse synchronization controller coupled between a pulse RF bias generator and a HIPIMs generator;
sending a first timing signal by the pulse synchronization controller to the pulse RF bias generator and the HIPIMs generator;
energizing a sputtering target and an RF electrode disposed in a substrate support based on the first timing signal;
de-energizing the target and the electrode based on an end of the timing signal;
sending a second timing signal by the pulse synchronization controller to the pulse RF bias generator; and
energizing and de-energizing the electrode without energizing the target in response to the second timing signal.

10. The method of claim 9, further comprising:
sending a third timing signal by the pulse synchronization controller to the pulse RF bias generator and the HIPIMs generator;
energizing the target and the RF mesh based on the third timing signal;
de-energizing the target and the RF mesh based on an end of the third timing signal;
sending a fourth timing signal by the pulse synchronization controller to the pulse RF bias generator; and
energizing and de-energizing the RF mesh without energizing the target in response to the third timing signal.

11. The method of claim 10, further comprising:
delaying the energizing of the RF mesh upon a start of the third timing signal.

12. The method of claim 11, wherein the delay in energizing the RF mesh is about 3 µs.

13. The method of any of claims 9 to 12, wherein the second timing signal is additionally sent to the HIPIMs generator and the HIPIMs generator energizes the target.
